# EUROPEAN PATENT APPLICATION

(11) **EP 4 331 835 A1**
(43) Date of publication of application: **06.03.2024**
(21) Application number: 22795482.3
(22) Date of filing: 29.03.2022
(51) Int. Cl.: B32B 15/08, B32B 15/082, B29C 65/14, H05K 1/03

(54) **BONDED BODY, SUBSTRATE, METHOD FOR PRODUCING BONDED BODY, AND METHOD FOR PRODUCING SUBSTRATE**

(30) Priority: 27.04.2021 JP 2021074939
(71) Applicant: The University of Tokyo, Bunkyo-ku, Tokyo 113-8654 (JP); DAIKIN INDUSTRIES, LTD., Osaka-Shi, Osaka 530-0001 (JP)
(72) Inventor: NAGATO, Keisuke, Tokyo 113-8654 (JP); AONO, Kota, Tokyo 113-8654 (JP); EBIHARA, Yusuke, Tokyo 113-8654 (JP); NAKAO, Masayuki, Tokyo 113-8654 (JP); UEDA, Yuki, Osaka-Shi, Osaka 530-0001 (JP); OKUNO, Shingo, Osaka-Shi, Osaka 530-0001 (JP); KOMORI, Hirokazu, Osaka-Shi, Osaka 530-0001 (JP); YAMAUCHI, Akiyoshi, Osaka-Shi, Osaka 530-0001 (JP); KISHIKAWA, Yosuke, Osaka-Shi, Osaka 530-0001 (JP)
(74) Representative: Hoffmann Eitle
(86) International application number: PCT/JP2022/015680
(87) International publication number: WO 2022/230566

(57) **Abstract**

Provided are a novel joined article having excellent shape stability, a novel substrate, a novel method for producing a joined article, and a novel method for producing a substrate. The joined article includes: a resin (1) having a linear expansion coefficient at 30°C to 200°C of 17 ppm/°C or higher and a thickness of 5 to 100 um; and a metal joined to a surface of the resin (1) and having a thickness of 5 to 50 um. The joined article has a curvature of -40 to 40/m.

## Description

### TECHNICAL FIELD

The disclosure relates to joined articles, substrates, methods for producing joined articles, and methods for producing substrates.

### BACKGROUND ART

Resin-metal joined articles are used in a variety of fields such as fields of electric devices, electronic devices, and telecommunications devices.

Patent Literatures 1 to 4 disclose joined articles including resin and metal joined together by laser irradiation.

### CITATION LIST

### - Patent Literature

Patent Literature 1: JP 2008-207540 A
Patent Literature 2: WO 2020/067022
Patent Literature 3: JP 2019-123153 A
Patent Literature 4: JP 2011-235570 A

### SUMMARY OF INVENTION

### - Technical Problem

The disclosure aims to provide a novel joined article having excellent shape stability, a novel substrate, a novel method for producing a joined article, and a novel method for producing a substrate.

### - Solution to Problem

The disclosure relates to a joined article (hereinafter, also referred to as a "first joined article" of the disclosure) including: a resin (1) having a linear expansion coefficient at 30°C to 200°C of 17 ppm/°C or higher and a thickness of 5 to 100 um; and a metal joined to a surface of the resin (1) and having a thickness of 5 to 50 um, the joined article having a curvature of -40 to 40/m.

The resin (1) preferably includes a fluororesin.

The resin (1) preferably consists essentially of the fluororesin.

The fluororesin preferably has a melting point of 320°C or lower.

The metal preferably includes copper.

The copper is preferably rolled copper or electrodeposited copper.

The joined article preferably has a ratio (the thickness of the metal)/(the thickness of the resin (1)) of 0.1 to 1.

The first joined article of the disclosure is preferably one in which the resin (1) and the metal are joined together using light that is absorbed by the metal at an absorbance of 5% or higher and absorbed by the resin (1) at an absorbance of 30% or lower, with an inequality (the absorbance of the metal) > (the absorbance of the resin (1)) satisfied.

Preferably, the joined article has a joined surface between the resin (1) and the metal, and the joined surface has a peel strength of 3 N/cm or higher measured in a 90-degree peel test or exhibits material failure in a 90-degree peel test.

The metal preferably has a surface roughness Rz of 2 um or lower at a surface joined to the resin (1).

The resin (1) preferably has been subjected to an adhesive surface treatment at a surface joined to the metal.

The first joined article of the disclosure is preferably a dielectric material for a substrate.

The disclosure also relates to a substrate (hereinafter, also referred to as a "first substrate" of the disclosure) including the first joined article of the disclosure and a resin (2) stacked on the first joined article.

The resin (2) preferably includes a thermosetting resin.

The thermosetting resin preferably includes at least one selected from the group consisting of polyimide, modified polyimide, epoxy resin, and thermosetting modified polyphenylene ether.

The resin (2) preferably includes at least one selected from the group consisting of a liquid crystal polymer, polyphenylene ether, thermoplastic modified polyphenylene ether, a cycloolefin polymer, a cycloolefin copolymer, polystyrene, and syndiotactic polystyrene.

The first substrate of the disclosure is preferably a printed circuit board, a multilayer circuit board, or a high frequency board.

The disclosure also relates to a method for producing a joined article, the method including: stacking a resin (1) having a thickness of 5 to 100 um and a linear expansion coefficient at 30°C to 200°C of 17 ppm/°C or higher and a metal having a thickness of 5 to 50 um; and joining the resin (1) and the metal by heating the resin (1) via the metal to provide a joined article having a curvature of -40 to 40/m.

The heating preferably includes applying light to the metal.

The light is preferably one that is absorbed by the metal at an absorbance of 5% or higher and absorbed by the resin (1) at an absorbance of 30% or lower, with an inequality (the absorbance of the metal) > (the absorbance of the resin (1)) satisfied.

The joined article is preferably a dielectric material for a substrate.

The disclosure also relates to a method for producing a substrate, the method including: joining a joined article obtained by the method for producing a joined article of the disclosure and a resin (2).

The resin (2) preferably includes a thermosetting resin.

The thermosetting resin preferably includes at least one selected from the group consisting of polyimide, modified polyimide, epoxy resin, and thermosetting modified polyphenylene ether.

The resin (2) preferably includes at least one selected from the group consisting of a liquid crystal polymer, polyphenylene ether, thermoplastic modified polyphenylene ether, a cycloolefin polymer, a cycloolefin copolymer, polystyrene, and syndiotactic polystyrene.

The substrate is preferably a printed circuit board, a multilayer circuit board, or a high frequency board.

The disclosure also relates to a joined article (a second joined article of the disclosure) including: a resin (1) having a linear expansion coefficient at 30°C to 200°C of 17 ppm/°C or higher and a thickness of 5 to 100 um; and a metal joined to a surface of the resin (1) and having a thickness of 5 to 50 um, the resin (1) including a heat-affected layer that is close to the metal and that occupies 80% or less of the thickness of the resin (1).

The second joined article of the disclosure preferably has a curvature of -40 to 40/m.

The resin (1) preferably includes a fluororesin.

The resin (1) preferably consists essentially of the fluororesin.

The metal preferably includes copper.

Preferably, the joined article has a joined surface between the resin (1) and the metal, and the joined surface has a peel strength of 3 N/cm or higher measured in a 90-degree peel test or exhibits material failure in a 90-degree peel test.

The second joined article of the disclosure is preferably a dielectric material for a substrate.

The disclosure also relates to a substrate (hereinafter, also referred to as a second substrate of the disclosure) including the second joined article of the disclosure and a resin (2) stacked on the second joined article.

The resin (2) preferably includes a thermosetting resin.

### - Advantageous Effects of Invention

The disclosure can provide a novel joined article having excellent shape stability, a novel substrate, a novel method for producing a joined article, and a novel method for producing a substrate.

### BRIEF DESCRIPTION OF THE DRAWINGS

FIG. 1 is a cross-sectional view of an example of a laminate for a substrate.
FIG. 2 is a schematic view of a modified example of a method for producing the laminate for a substrate shown in FIG. 1.
FIG. 3 is a schematic view of an example of a method for producing a single-sided joined article shown in FIG. 2.
FIG. 4 is a photograph of a warped single-sided joined article.
FIG. 5 is a schematic view of an example of light application from the side of the resin (1).
FIG. 6 is an enlarged view of a light-irradiated portion (dotted circle) in FIG. 5.

### DESCRIPTION OF EMBODIMENTS

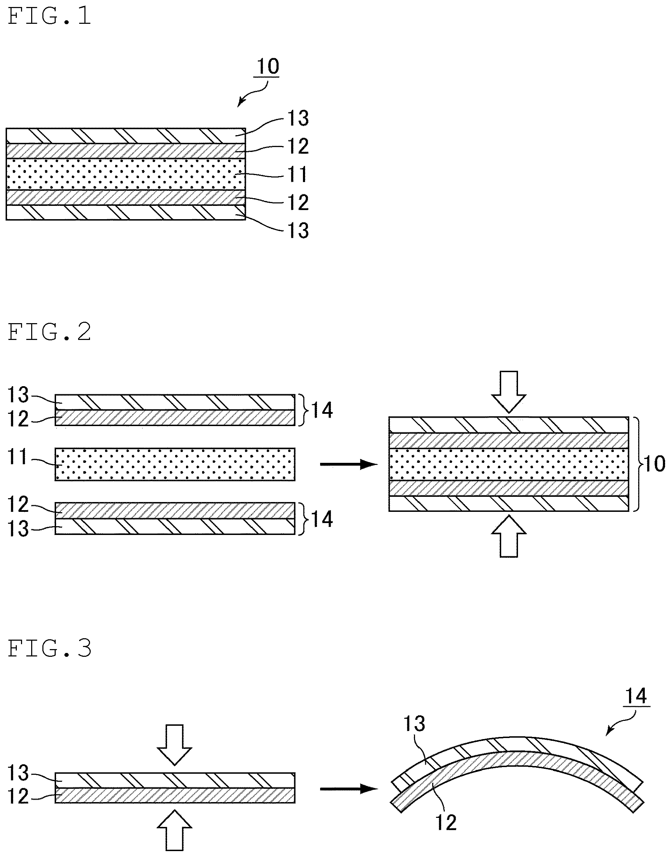

FIG. 1 is a schematic view of an example of a laminate for a substrate.

As shown in FIG. 1, a laminate 10 for a substrate has a structure including a core layer 11 formed from an epoxy resin, for example, and successively a fluororesin 12 and a metal 13 stacked on upper and lower surfaces of the core layer 11. The core layer 11 and the fluororesin 12 serve as insulating layers of the substrate.

This laminate 10 for a substrate may be produced by stacking the core layer 11, the fluororesin 12, and the metal 13, and then joining (bonding) these components by heating and pressurization with a press, for example. The resin of the core layer 11 and the fluororesin 12 may have different heating temperatures for joining. For example, the heating temperature for epoxy resin is about 180°C, while the heating temperature for fluororesin is about 320°C. In this case, the laminate 10 for a substrate is not successfully obtained by joining the core layer 11, the fluororesin 12, and the metal 13 in one step.

The inventors studied methods for solving this issue to arrive at the following production method. FIG. 2 is a schematic view of a modified example of a method for producing the laminate for a substrate shown in FIG. 1.

In the production method of FIG. 2, a metal 13 is joined to one surface of a fluororesin 12 to form a single-sided joined article 14 and a core layer 11 is sandwiched by a pair of the single-sided joined articles. The workpiece is then heated and pressurized using a press, for example. Thereby, the fluororesins 12 and the core layer 11 are joined and a laminate 10 for a substrate is provided. Since the fluororesin 12 and the metal 13 have been already joined together, the heating in this process is performed at the heating temperature for the resin of the core layer 11. Thus, the single-sided joined articles 14 enable production of a laminate 10 for a substrate in one step by the production method of FIG. 2.

In the production method of FIG. 2, the single-sided joined articles 14 are prepared in advance. FIG. 3 is a schematic view of an example of a method for producing the single-sided joined article shown in FIG. 2.

As shown in FIG. 3, the single-sided joined article 14 may presumably be produced by stacking the fluororesin 12 and the metal 13 and then heating and pressurizing the workpiece with a press, for example. This operation causes deformation of the fluororesin 12 by thermal expansion or thermal shrinkage due to heating. The metal 13, which is commonly a thin metal foil for the use in a substrate, follows this deformation of the fluororesin 12, resulting in a warp of the single-sided joined article 14.

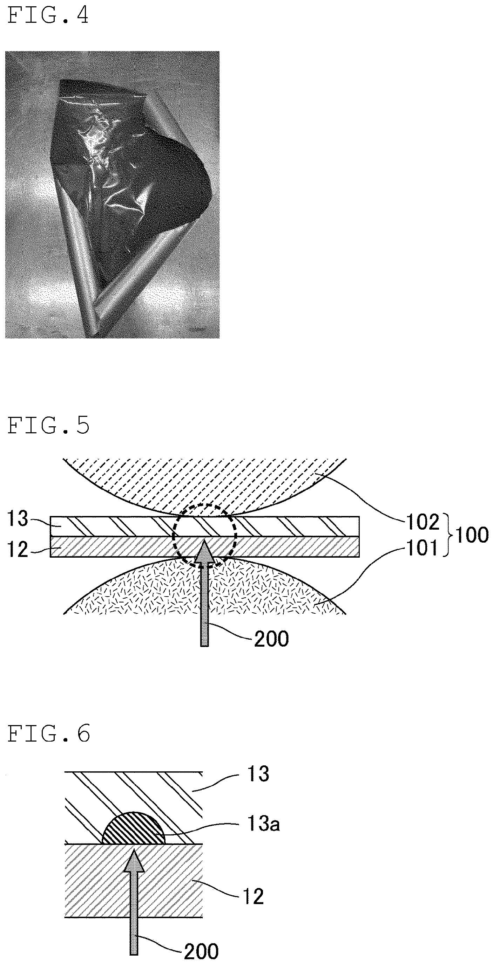

FIG. 4 is a photograph of a warped single-sided joined article. The single-sided joined article 14 in this state is difficult to stack on a core layer 11. Therefore, the production method of FIG. 2 is not easy to perform.

The inventors studied the above issue to find that the issue can be solved under the conditions where the thickness and linear expansion coefficient of the resin, the thickness of the metal, and the curvature of the components joined together fall within the respective specific ranges, arriving at the joined article of the disclosure.

The disclosure will be specifically described hereinbelow.

### (First joined article)

The first joined article of the disclosure includes: a resin (1) having a linear expansion coefficient at 30°C to 200°C of 17 ppm/°C or higher and a thickness of 5 to 100 um; and a metal joined to a surface of the resin (1) and having a thickness of 5 to 50 um, and has a curvature of - 40 to 40/m.

The first joined article of the disclosure is easily stacked on another layer because it has a curvature of -40 to 40/m while the resin (1) and the metal are in a joined state. Thus, using the first joined article of the disclosure easily enables the production method of FIG. 2, which can provide a laminate for a substrate in one step.

The thickness of the resin (1) is 5 to 100 um, preferably 10 um or greater, more preferably 12 um or greater, while preferably 90 um or smaller, more preferably 80 um or smaller.

The resin (1) is preferably in the form of sheet having a substantially constant thickness. In the case where the resin (1) includes portions having different thicknesses, the thickness refers to an average of the thicknesses measured at the points defined by dividing the resin (1) into 10 equal parts in the longitudinal direction.

The linear expansion coefficient at 30°C to 200°C of the resin (1) is 17 ppm/°C or higher, preferably 50 ppm/°C or higher, more preferably 100 ppm/°C or higher, while preferably 500 ppm/°C or lower, more preferably 300 ppm/°C or lower.

The linear expansion coefficient of the resin (1) is a value determined by thermomechanical analysis (TMA).

The resin (1) may have any relative permittivity and any dissipation factor. The relative permittivity at 25°C and a frequency of 10 GHz is preferably 4.5 or lower, more preferably 4.0 or lower, still more preferably 3.5 or lower, particularly preferably 2.5 or lower. The dissipation factor is preferably 0.01 or lower, more preferably 0.008 or lower, still more preferably 0.005 or lower.

The relative permittivity and dissipation factor of the resin (1) are values measured by a split cylinder resonator method.

The resin (1) used may be a fluororesin, a liquid crystal polymer, polyimide, modified polyimide, a cycloolefin polymer, a cycloolefin copolymer, polystyrene, or syndiotactic polystyrene, for example. In terms of electric properties such as insulation, preferred is a fluororesin, more preferred is a melt-moldable fluororesin.

The fluororesin used may be a polymer of tetrafluoroethylene (TFE) or a copolymer of TFE and a copolymerizable monomer copolymerizable with TFE.

The copolymerizable monomer may be any monomer copolymerizable with TFE, and examples thereof include hexafluoropropylene (HFP), a fluoroalkyl vinyl ether, a fluoroalkylethylene, a fluoromonomer represented by the formula (100): CH₂=CFRf¹⁰¹ (wherein Rf¹⁰¹ is a C1-C12 linear or branched fluoroalkyl group), and a fluoroalkyl allyl ether.

The fluoroalkyl vinyl ether preferably includes at least one selected from the group consisting of:
a fluoromonomer represented by the formula (110):

CF₂=CF-ORf¹¹¹

wherein Rf¹¹¹ is a perfluoro organic group;
   a fluoromonomer represented by the formula (120):

   CF₂=CF-OCH₂-Rf¹²¹
wherein Rf¹²¹ is a C1-C5 perfluoroalkyl group;
   a fluoromonomer represented by the formula (130):

   CF₂=CFOCF₂ORf¹³¹
wherein Rf¹³¹ is a C1-C6 linear or branched perfluoroalkyl group, a C5-C6 cyclic perfluoroalkyl group, or a C2-C6 linear or branched perfluorooxyalkyl group containing one to three oxygen atoms;
   a fluoromonomer represented by the formula (140):

   CF₂=CFO(CF₂CF(Y¹⁴¹)O)ₘ(CF₂)ₙF
wherein Y¹⁴¹ is a fluorine atom or a trifluoromethyl group; m is an integer of 1 to 4; and n is an integer of 1 to 4; and
   a fluoromonomer represented by the formula (150):

   CF₂=CF-O-(CF₂CFY¹⁵¹-O)ₙ-(CFY¹⁵²)ₘ-A¹⁵¹
wherein
   Y¹⁵¹ is a fluorine atom, a chlorine atom, a -SO₂F group, or a perfluoroalkyl group, where the perfluoroalkyl group optionally contains ether oxygen and a -SO₂F group;
   n is an integer of 0 to 3, n Y¹⁵¹s are the same as or different from each other;
   Y¹⁵² is a fluorine atom, a chlorine atom, or a -SO₂F group;
   m is an integer of 1 to 5, m Y¹⁵²s are the same as or different from each other;
   A¹⁵¹ is -SO₂X¹⁵¹, -COZ¹⁵¹, or -POZ¹⁵²Z¹⁵³, where X¹⁵¹ is F, Cl, Br, I, -OR¹⁵¹, or -NR¹⁵²R¹⁵³; Z¹⁵¹, Z¹⁵², and Z¹⁵³ are the same as or different from each other and are each -NR¹⁵⁴R¹⁵⁵ or -OR¹⁵⁶; R¹⁵¹, R¹⁵², R¹⁵³, R¹⁵⁴, R¹⁵⁵, and R¹⁵⁶ are the same as or different from each other and are each H, ammonium, an alkali metal, an alkyl group, aryl group, or sulfonylcontaining group optionally containing a fluorine atom.

The "perfluoro organic group" herein means an organic group in which all hydrogen atoms bonded to any carbon atom are replaced by fluorine atoms. The perfluoro organic group may contain ether oxygen.

An example of the fluoromonomer represented by the formula (110) may be a fluoromonomer in which Rf¹¹¹ is a C1-C10 perfluoroalkyl group. The carbon number of the perfluoroalkyl group is preferably 1 to 5.

Examples of the perfluoro organic group in the formula (110) include a perfluoromethyl group, a perfluoroethyl group, a perfluoropropyl group, a perfluorobutyl group, a perfluoropentyl group, and a perfluorohexyl group.

The fluoromonomer represented by the formula (110) may also be, for example, a monomer represented by the formula (110) in which Rf¹¹¹ is a C4-C9 perfluoro(alkoxyalkyl)group, a monomer in which Rf¹¹¹ is a group represented by the following formula: 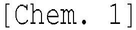 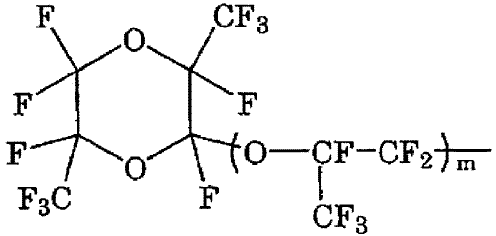
wherein m is 0 or an integer of 1 to 4; and a monomer in which Rf¹¹¹ is a group represented by the following formula: 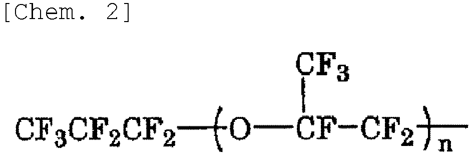
wherein n is an integer of 1 to 4.

In particular, the fluoromonomer represented by the formula (110) is preferably a perfluoro(alkyl vinyl ether) (PAVE), more preferably a fluoromonomer represented by the formula (160):

CF₂=CF-ORf¹⁶¹

(wherein Rf¹⁶¹ is a C1-C10 perfluoroalkyl group). Rf¹⁶¹ is preferably a C1-C5 perfluoroalkyl group.

The fluoroalkyl vinyl ether preferably includes at least one selected from the group consisting of fluoromonomers represented by any of the formulas (160), (130), and (140).

The fluoromonomer (PAVE) represented by the formula (160) preferably includes at least one selected from the group consisting of perfluoro(methyl vinyl ether) (PMVE), perfluoro(ethyl vinyl ether) (PEVE), and perfluoro(propyl vinyl ether) (PPVE), more preferably includes at least one selected from the group consisting of perfluoro(methyl vinyl ether) and perfluoro(propyl vinyl ether).

The fluoromonomer represented by the formula (130) preferably includes at least one selected from the group consisting of CF₂=CFOCF₂OCF₃, CF₂=CFOCF₂OCF₂CF₃, and CF₂=CFOCF₂OCF₂CF₂OCF₃.

The fluoromonomer represented by the formula (140) preferably includes at least one selected from the group consisting of CF₂=CFOCF₂CF(CF₃)O(CF₂)₃F, CF₂=CFO(CF₂CF(CF₃)O)₂(CF₂)₃F, and CF₂=CFO(CF₂CF(CF₃)O)₂(CF₂)₂F.

The fluoromonomer represented by the formula (150) preferably includes at least one selected from the group consisting of CF₂=CFOCF₂CF₂SO₂F, CF₂=CFOCF₂CF(CF₃)OCF₂CF₂SO₂F, CF₂=CFOCF₂CF(CF₂CF₂SO₂F)OCF₂CF₂SO₂F, and CF₂=CFOCF₂CF(SO₂F)₂.

The fluoromonomer represented by the formula (100) is preferably a fluoromonomer in which Rf¹⁰¹ is a linear fluoroalkyl group, more preferably a fluoromonomer in which Rf¹⁰¹ is a linear perfluoroalkyl group. Rf¹⁰¹ preferably has a carbon number of 1 to 6. Examples of the fluoromonomer represented by the formula (100) include CH₂=CFCF₃, CH₂=CFCF₂CF₃, CH₂=CFCF₂CF₂CF₃, CH₂=CFCF₂CF₂CF₂H, CH₂=CFCF₂CF₂CF₂CF₃, CHF=CHCF₃ (E configuration), and CHF=CHCF₃ (Z configuration). Preferred among these is 2,3,3,3-tetrafluoropropylene represented by CH₂=CFCF₃.

The fluoroalkylethylene is preferably a fluoroalkylethylene represented by the formula (170):

CH₂=CH-(CF₂)ₙ-X¹⁷¹

(wherein X¹⁷¹ is H or F; and n is an integer of 3 to 10), and more preferably includes at least one selected from the group consisting of CH₂=CH-C₄F₉ and CH₂=CH-C₆F₁₃.

The fluoroalkyl allyl ether may be a fluoromonomer represented by the formula (180):

CF₂=CF-CF₂-ORf¹¹¹

wherein Rf¹¹¹ is a perfluoro organic group.

Rf¹¹¹ of the formula (180) is defined in the same manner as Rf¹¹¹ of the formula (110). Rf¹¹¹ is preferably a C1-C10 perfluoroalkyl group or a C1-C10 perfluoroalkoxyalkyl group. The fluoroalkyl allyl ether represented by the formula (180) preferably includes at least one selected from the group consisting of CF₂=CF-CF₂-O-CF₃, CF₂=CF-CF₂-O-C₂F₅, CF₂=CF-CF₂-O-C₃F₇, and CF₂=CF-CF₂-O-C₄F₉, more preferably includes at least one selected from the group consisting of CF₂=CF-CF₂-O-C₂F₅, CF₂=CF-CF₂-O-C₃F₇, and CF₂=CF-CF₂-O-C₄F₉, and is still more preferably CF₂=CF-CF₂-O-CF₂CF₂CF₃.

The copolymerizable monomer preferably includes at least one selected from the group consisting of a fluoroalkyl allyl ether, PAVE, and HFP. In order to reduce deformation of the fluororesin material during soldering, PAVE is more preferred.

In a preferred embodiment, the fluororesin is a TFE/PAVE copolymer (PFA) containing a TFE unit and a PAVE unit. In the case of PFA, the fluororesin preferably contains a fluoroalkyl allyl ether unit or a PAVE unit in an amount of 0.1 to 12% by mass of all polymerized units. The amount of the fluoroalkyl allyl ether unit or PAVE unit is more preferably 0.3% by mass or more, still more preferably 0.7% by mass or more, further preferably 1.0% by mass or more, particularly preferably 1.1% by mass or more, while more preferably 8.0% by mass or less, still more preferably 6.5% by mass or less, particularly preferably 6.0% by mass or less of all polymerized units.

The amount of the fluoroalkyl allyl ether unit or PAVE unit is determined by ¹⁹F-NMR. The same applies to the TFE unit and the HFP unit to be described later.

In a preferred embodiment, the fluororesin is a TFE/HFP copolymer (FEP) containing a TFE unit and a HFP unit. In the case where the fluororesin is FEP, the TFE unit and the HFP unit preferably have a mass ratio (TFE/HFP) of (70 to 99)/(1 to 30) (% by mass). The mass ratio (TFE/HFP) is more preferably (85 to 95)/(5 to 15) (% by mass).

The FEP contains the HFP unit in an amount of 1% by mass or more, preferably 1.1% by mass or more of all monomer units.

The FEP preferably contains a fluoroalkyl allyl ether unit or a perfluoro(alkyl vinyl ether) (PAVE) unit together with the TFE unit and the HFP unit.

Examples of the fluoroalkyl allyl ether unit and the PAVE unit contained in the FEP include the same as those for the fluoroalkyl allyl ether unit and the PAVE unit in the aforementioned PFA. Preferred among these is PPVE.

The aforementioned PFA contains no HFP unit and is therefore different from FEP containing a PAVE unit in this respect.

In the case where the FEP contains a TFE unit, a HFP unit, and a fluoroalkyl allyl ether unit or PAVE unit, the mass ratio (TFE/HFP/fluoroalkyl allyl ether or PAVE) is preferably (70 to 99.8)/(0.1 to 25)/(0.1 to 25) (% by mass). The mass ratio within the above range can lead to a fluororesin material having excellent heat resistance and excellent chemical resistance.

The mass ratio (TFE/HFP/fluoroalkyl allyl ether or PAVE) is more preferably (75 to 98)/(1.0 to 15)/(1.0 to 10) (% by mass).

The FEP contains the HFP unit and the PAVE unit in a total amount of 1% by mass or more, preferably 1.1% by mass or more of all monomer units.

In the FEP containing a TFE unit, a HFP unit, and a fluoroalkyl allyl ether unit or PAVE unit, the HFP unit preferably represents 25% by mass or less of all monomer units.

The HFP unit in an amount within the above range can lead to a fluororesin material having excellent heat resistance.

The amount of the HFP unit is more preferably 20% by mass or less, still more preferably 18% by mass or less, particularly preferably 15% by mass or less. The amount of the HFP unit is also preferably 0.1% by mass or more, more preferably 1% by mass or more, particularly preferably 2% by mass or more.

The amount of the HFP unit can be determined by ¹⁹F-NMR.

The amount of the fluoroalkyl allyl ether unit or PAVE unit is more preferably 20% by mass or less, still more preferably 10% by mass or less, particularly preferably 3% by mass or less. The amount of the fluoroalkyl allyl ether unit or PAVE unit is preferably 0.1% by mass or more, more preferably 1% by mass or more. The amount of the fluoroalkyl allyl ether unit or PAVE unit can be determined by ¹⁹F-NMR.

The FEP may further contain a different ethylenic monomer (α) unit.

The different ethylenic monomer (α) unit may be any monomer unit copolymerizable with TFE, HFP, a fluoroalkyl allyl ether, and PAVE. Examples thereof include fluorinecontaining ethylenic monomers such as vinyl fluoride (VF), vinylidene fluoride (VdF), chlorotrifluoroethylene (CTFE), and ethylene (Et) and non-fluorinated ethylenic monomers such as ethylene, propylene, and alkyl vinyl ethers.

In the case where the FEP contains a TFE unit, a HFP unit, a fluoroalkyl allyl ether unit or PAVE unit, and a different ethylenic monomer (α) unit, the mass ratio (TFE/HFP/fluoroalkyl allyl ether or PAVE/different ethylenic monomer (α) unit) is preferably (70 to 98)/(0.1 to 25)/(0.1 to 2 5) / (0.1 to 25) (% by mass) .

The FEP contains the monomer units excluding the TFE unit in a total amount of 1% by mass or more, preferably 1.1% by mass or more of all monomer units.

The fluororesin also preferably includes PFA and FEP. In other words, PFA and FEP may be mixed with each other for use. The PFA and the FEP preferably have a mass ratio (PFA/FEP) of 9/1 to 3/7, more preferably 9/1 to 5/5.

The PFA and the FEP may be produced, for example, by a conventionally known method in which monomers to serve as structural units and additives such as a polymerization initiator are mixed with each other as appropriate for emulsion polymerization or suspension polymerization.

The fluororesin preferably has a melting point of 320°C or lower. This enables easy welding by optical heating.

The melting point of the fluororesin is more preferably 318°C or lower, still more preferably 315°C or lower, while preferably 250°C or higher, more preferably 280°C or higher.

The melting point of the fluororesin is the temperature corresponding to the maximum value on a heatof-fusion curve with a temperature-increasing rate of 10°C/min using a differential scanning calorimeter (DSC).

The fluororesin preferably has a melt flow rate (MFR) at 372°C of 0.1 to 100 g/10 min. This enables easy welding by optical heating.

The MFR is more preferably 0.5 g/10 min or higher, while more preferably 80 g/10 min or lower, still more preferably 40 g/10 min or lower.

The MFR is a value obtained in conformity with ASTM D1238 using a melt indexer (available from Yasuda Seiki Seisakusho Ltd.), as the mass (g/10 min) of a polymer flowing out of a nozzle (inner diameter: 2 mm, length: 8 mm) per 10 minutes at a temperature of 372°C and a load of 5 kg.

The resin (1) contains the fluororesin in an amount of preferably 50% by mass or more, more preferably 60% by mass or more. The upper limit may be, but is not limited to, 100% by mass. In terms of electric properties, the resin (1) preferably consists essentially of a fluororesin (the amount of the fluororesin contained in the resin (1) is preferably 99% by mass or more).

In terms of joining strength between the resin (1) and the metal, the resin (1) preferably has been subjected to an adhesive surface treatment at a surface joined to the metal.

Examples of the adhesive surface treatment include etching, plasma treatment, corona treatment, and photochemical treatment. Preferred are plasma treatment and corona treatment.

The conditions for the adhesive surface treatment may be set as appropriate in accordance with the properties such as the composition of the resin (1).

In order to improve the joining strength, an adhesive layer may be provided between the resin (1) and the metal. The adhesive layer may be, but is not limited to, a layer formed from adhesive.

Examples of the adhesive include, but are not limited to, PTFE super power adhesive bond available from Flon Industry, PPX set available from Cemedine Co., Ltd., and low-temperature-curable adhesive available from ThreeBond Holdings Co., Ltd. Preferred is an adhesive for fluorine material.

A bonding sheet may be used as adhesive. The bonding sheet may be, but is not limited to, a plasma-treated silicone resin (PDMS). Commercially available bonding sheets include a heat-resistant bonding film available from Toagosei Co., Ltd., D5200 series available from Dexerials Corp., and A23 type available from Arisawa Manufacturing Co., Ltd.

The metal has a thickness of 5 to 50 um, preferably 7 um or greater, more preferably 9 um or greater, while preferably 45 um or smaller, more preferably 40 um or smaller.

The metal is preferably in the form of metal foil having a substantially constant thickness. In the case where the metal includes portions having different thicknesses, the thickness refers to an average of the thicknesses measured at the points defined by dividing the metal into 10 equal parts in the longitudinal direction.

The ratio (the thickness of the metal)/(the thickness of the resin (1)) is preferably 0.1 to 1.

The lower limit thereof is more preferably 0.15, still more preferably 0.2, while the upper limit is more preferably 0.95, still more preferably 0.9.

The metal preferably includes at least one selected from the group consisting of copper, stainless steel, aluminum, iron, silver, gold, ruthenium, and alloys of any of these, more preferably includes at least one selected from the group consisting of copper, silver, gold, stainless steel, and aluminum, and is still more preferably copper.

Examples of the stainless steel include austenite stainless steel, martensite stainless steel, and ferrite stainless steel.

Examples of the copper include rolled copper and electrodeposited copper.

The metal preferably has a surface roughness Rz of 2 um or lower at a surface joined to the resin (1). This can lead to a lower transmission loss of the joined article of the resin (1) and the metal.

The surface roughness Rz is more preferably 1.8 um or lower, still more preferably 1.5 um or lower, while more preferably 0.3 um or higher, still more preferably 0.5 um or higher.

The surface roughness Rz is a value calculated by the method of JIS C6515-1998 (maximum height roughness).

Preferably, the joined surface between the resin (1) and the metal has a peel strength of 3 N/cm or higher measured in a 90-degree peel test or exhibits material failure in a 90-degree peel test. The peel strength is more preferably 4 N/cm or higher, still more preferably 5 N/cm or higher. The upper limit is not limited.

The 90-degree peel test is performed by the method in conformity with JIS C6481-1996.

The first joined article of the disclosure has a curvature of -40 to 40/m. The first joined article having a curvature within this range is easily stacked on another layer.

In terms of shape stability, the curvature is preferably -35/m or higher, more preferably -20/m or higher, still more preferably -10/m or higher, while preferably 35/m or lower, more preferably 20/m or lower, still more preferably 10/m or lower.

The first joined article of the disclosure is obtainable by joining the resin (1) and the metal.

The resin (1) and the metal may be joined by any known method such as using a press. In terms of shape stability, joining is preferably performed by a heat treatment to be described in the method for producing a joined article of the disclosure to be described later. In other words, the first joined article of the disclosure is suitably obtainable by the method for producing a joined article of the disclosure to be described later.

The first joined article of the disclosure is preferably formed by joining using light that is absorbed by the metal at an absorbance of 5% or higher and absorbed by the resin (1) at an absorbance of 30% or lower. The light is the same as light used in the method for producing a joined article of the disclosure to be described later.

The orientation of the resin (1) is changed at a portion heated. For example, in the case where the resin (1) is heated from the side of the metal, the orientation is different between the portion adjacent to the metal and the portion opposite thereto. Thus, the orientation of the resin can be used to confirm whether the heat treatment is performed.

In the resin (1), the portion heated and thereby changed in orientation from its non-heated state is referred to as a heat-affected layer. The heat-affected layer of the resin (1) close to the metal has a thickness that is preferably 80% or less, more preferably 70% or less, still more preferably 60% or less of the thickness of the resin (1). The lower limit may be, but is not limited to, 5% or less as long as bonding to the metal is observed.

The heat-affected layer can be checked by observing a cross section of a slice obtained by cutting the joined article in the width direction. The cut width (thickness of the slice used in observing the cross section) is about 20 to 50 um. The observation technique may be, but is not limited to, polarized optical microscopy or Raman spectroscopy.

The first joined article of the disclosure is suitably used as a dielectric material for a substrate.

In the first joined article of the disclosure, the resin (1) is joined with the metal on at least one surface. In the production method of FIG. 2, preferably, the resin (1) is joined with the metal only on a single surface (either the front surface or the back surface in the case where the resin (1) has a sheet shape) and is joined with nothing on the other surfaces. The metal is joined with the resin (1) on at least one surface. In the production method of FIG. 2, preferably, the metal is joined with the resin (1) only on a single surface (either the front surface or the back surface in the case where the metal is metal foil) and is joined with nothing on the other surfaces. In other words, the first joined article of the disclosure is preferably a single-sided joined article in which one layer of the resin (1) and one layer of the metal are joined together.

### (First substrate)

The first substrate of the disclosure includes the first joined article of the disclosure and a resin (2) stacked thereon.

In the case where the resin (1) is a fluororesin and the resin (2) is a resin having a lower melting point than the fluororesin (e.g., epoxy resin), they have different heating temperatures for joining. Still, in the first substrate of the disclosure, the joining is performed at the heating temperature for the resin (2), which can lead to an effect of providing a substrate in one step.

In the first substrate of the disclosure, the resin (2) is preferably stacked on the surface of the resin (1) of the first joined article of the disclosure. In other words, the first substrate of the disclosure is preferably a laminate of the metal, the resin (1), and the resin (2) in this order.

Also, the first substrate of the disclosure is preferably a laminate as shown in FIG. 2 including the resin (2) and the first joined article of the disclosure stacked on both the upper and lower surfaces thereof. In other words, the first substrate of the disclosure is preferably a laminate of the metal, the resin (1), the resin (2), the resin (1), and the metal in this order.

The resin (2) used is preferably a thermosetting resin.

The thermosetting resin preferably includes at least one selected from the group consisting of polyimide, modified polyimide, epoxy resin, and thermosetting modified polyphenylene ether, and is more preferably epoxy resin, modified polyimide, or thermosetting modified polyphenylene ether, still more preferably epoxy resin or thermosetting modified polyphenylene ether.

The resin (2) may be a resin other than the thermosetting resin.

The resin other than the thermosetting resin preferably includes at least one selected from the group consisting of a liquid crystal polymer, polyphenylene ether, thermoplastic modified polyphenylene ether, a cycloolefin polymer, a cycloolefin copolymer, polystyrene, and syndiotactic polystyrene.

The resin (2) has a thickness of preferably 5 um or greater, more preferably 10 um or greater, while preferably 2000 um or smaller, more preferably 1500 um or smaller.

The resin (2) is preferably in the form of sheet having a substantially constant thickness. In the case where the resin (2) includes portions having different thicknesses, the thickness refers to an average of the thicknesses measured at the points defined by dividing the resin (2) into 10 equal parts in the longitudinal direction.

The first substrate of the disclosure has a thickness of preferably 20 um or greater, more preferably 30 um or greater, while preferably 5000 um or smaller, more preferably 3000 um or smaller.

The first substrate of the disclosure is preferably in the form of sheet having a substantially constant thickness. In the case where the first substrate of the disclosure includes portions having different thicknesses, the thickness refers to an average of the thicknesses measured at the points defined by dividing the first substrate of the disclosure into 10 equal parts in the longitudinal direction.

The first substrate of the disclosure is suitably used as a printed circuit board, a multilayer circuit board (multilayer substrate), or a high frequency board.

The high frequency circuit board is a circuit board capable of operating within a high frequency band. The high frequency band may be a band of 1 GHz or higher, preferably a band of 3 GHz or higher, more preferably a band of 5 GHz or higher. The upper limit may be, but is not limited to, a band of 100 GHz or lower.

### (Method for producing joined article)

The method for producing a joined article of the disclosure includes: stacking a resin (1) having a linear expansion coefficient at 30°C to 200°C of 17 ppm/°C or higher and a thickness of 5 to 100 um and a metal having a thickness of 5 to 50 um; and joining the resin (1) and the metal by heating the resin (1) via the metal to provide a joined article having a curvature of -40 to 40/m.

The resin (1) and the metal are the same as those described for the first joined article of the disclosure.

If the resin (1) and the metal are heated using a press, the whole resin (1) is heated so that the resin (1) tends to deform greatly, resulting in a warped joined article as shown in FIGs. 3 and 4.

In contrast, in the method for producing a joined article of the disclosure, the resin (1) is not entirely heated but is selectively heated only at a portion in contact with the metal owing to the heating treatment on the resin (1) via the metal. This can reduce deformation of the resin (1), easily providing a joined article having a curvature of -40 to 40/m.

The heating treatment may be application of electromagnetic radiation, for example. The electromagnetic radiation is classified by wavelength into gamma rays, X-rays, ultraviolet radiation, visible light, infrared radiation, radio waves, microwaves, very high frequency waves, high frequency waves, medium frequency waves, low frequency waves, very low frequency waves, and extremely low frequency waves, for example. The electromagnetic radiation is of a type of preferably radio waves, light (e.g., ultraviolet radiation, visible light, infrared radiation), X-rays, or gamma rays, more preferably radio waves or light, still more preferably light.

The electromagnetic radiation such as light may be applied from the side of the metal or may be applied from the side of the resin (1), and is preferably applied from the side of the resin (1). Applying the electromagnetic radiation from the side of the resin (1) can reduce the amount of heat applied to the metal and can more reduce deformation of the resin (1).

Applying light from the side of the resin (1) is effective in the case where the light transmits the resin (1) and the light is absorbed by the metal.

Such light to be used is preferably light that is absorbed by the metal at an absorbance of 5% or higher and absorbed by the resin (1) at an absorbance of 30% or lower, with an inequality (the absorbance of the metal) > (the absorbance of the resin (1)) satisfied. The absorbance of the metal is preferably 10% or higher, more preferably 15% or higher, with no upper limit. The absorbance of the resin (1) is preferably 25% or lower, more preferably 20% or lower, with no lower limit. The difference between the absorbance of the metal and the absorbance of the resin (1), i.e., (the absorbance of the metal) - (the absorbance of the resin (1)), is preferably 5% or higher, more preferably 10% or higher, with no upper limit.

The metal and the resin (1) are the same as those described for the first joined article of the disclosure.

The absorbances are values of a metal having a thickness of 12 um or a resin (1) having a thickness of 25 um measured using a UV-VIS-NIR spectrophotometer (e.g., "V-770" available from Jasco Corp.). The metal is analyzed in the surface reflection geometry and the resin (1) is analyzed in the transmission geometry.

Specific examples of the light include a laser, and light emitted from any of devices such as a halogen lamp, a xenon lamp, a far-infrared heater, and a microwave generator. Preferred is a laser.

Examples of the laser include a fiber laser, a YAG laser, a disk laser, a semiconductor laser, a CO₂ laser, a He-Ne laser, an excimer laser, and an argon laser. Preferred are a fiber laser and a YAG laser, more preferred is a fiber laser.

The light has a wavelength of preferably 200 nm or longer, more preferably 400 nm or longer, still more preferably 500 nm or longer, while preferably 10000 nm or shorter, more preferably 2500 nm or shorter, still more preferably 2000 nm or shorter.

The power/(spot size × scanning speed) value in the light application is preferably 0.01 J/mm² or higher, more preferably 0.03 J/mm² or higher, still more preferably 0.05 J/mm² or higher, while preferably 0.20 J/mm² or lower, more preferably 0.15 J/mm² or lower, still more preferably 0.10 J/mm² or lower.

The light may be applied from the side of the resin (1) by any method. In terms of production efficiency, the method illustrated in FIG. 5 is preferred. FIG. 5 is a schematic view of an example of light application from the side of the resin (1).

In the example of FIG. 5, a resin (1) 12 and a metal 13 are stacked and the workpiece is then pressurized in a roll-to-roll manner using a pressing device 100. The pressing device 100 includes a resin-side roll 101 positioned at a lower part in FIG. 4 and a metal-side roll 102 positioned at an upper part in FIG. 4. The resin-side roll 101 and the metal-side roll 102 pressurize the resin (1) 12 and the metal 13.

Light 200 is applied to the fluororesin 12 via the resin-side roll 101. FIG. 6 is an enlarged view of a light-irradiated portion (dotted circle) in FIG. 5.

As shown in FIG. 6, the metal 13 partially becomes hot when heated by the light 200. The heated portion is illustrated as a high-temperature portion 13a. The resin (1) 12 is heated and melts only at an outermost surface in contact with the high-temperature portion 13a. Thereby, the resin (1) 12 and the metal 13 are joined (bonded) together.

The resin-side roll 101 may be formed from any material having a light absorbance of 20% or lower, such as glass, thermoplastic resin, or thermosetting resin. Preferred are glass and thermoplastic resin, more preferred is glass.

The absorbance is a value measured using a UV-VIS-NIR spectrophotometer. The light used in the measurement is that described for the method for producing the joined article of the disclosure.

### (Method for producing substrate)

The method for producing a substrate of the disclosure includes joining a joined article obtained by the method for producing a joined article of the disclosure and a resin (2).

The resin (2) is the same as that described for the first substrate of the disclosure.

In the method for producing a substrate of the disclosure, a joined article in which the resin (1) and the metal have already been joined together is joined with a resin (2). This method therefore effectively enables easy setting of temperature conditions upon bonding and reduction in the number of processing steps in comparison with a method of simultaneously joining the resin (1), the metal, and the resin (2).

The joined article and the resin (2) can be joined by a known method such as using a press.

The thickness, preferred uses, and the like of the substrate obtainable by the method for producing a substrate of the disclosure are the same as those described for the first substrate of the disclosure.

### (Second joined article of the disclosure)

The second joined article of the disclosure includes: a resin (1) having a linear expansion coefficient at 30°C to 200°C of 17 ppm/°C or higher and a thickness of 5 to 100 um; and a metal joined to a surface of the resin (1) and having a thickness of 5 to 50 um, the resin (1) including a heat-affected layer that is close to the metal and that occupies 80% or less of the thickness of the resin (1).

Deformation of the resin due to heating is presumably caused by a change in the crystalline state of the resin due to heating. In the second joined article of the disclosure, the heat-affected layer of the resin (1) close to the metal occupies a predetermined percentage or lower of the thickness of the resin (1). This can lead to a joined article including the resin (1) and the metal joined together while reducing deformation of the resin (1).

The heat-affected layer of the resin (1) close to the metal occupies 80% or less, preferably 70% or less, more preferably 60% or less of the thickness of the resin (1). The lower limit may be, but is not limited to, 5% or less as long as bonding to the metal is observed.

A method of partially changing the crystalline state of the resin (1), i.e., a method of forming a heat-affected layer only in part of the resin (1) may be, but is not limited to, a method of selectively heating the resin (1) only at a portion in contact with the metal, as in the case of the method for producing a joined article of the disclosure. The method for producing a joined article of the disclosure can form a heat-affected layer only at a portion of the resin (1) close to the metal.

The second joined article of the disclosure has a curvature of preferably -40/m or higher, more preferably - 35/m or higher, still more preferably -20/m or higher, particularly preferably -10/m or higher, while preferably 40/m or lower, more preferably 35/m or lower, still more preferably 20/m or lower, particularly preferably 10/m or lower.

The resin (1) and the metal in the second joined article of the disclosure are the same as those described for the first joined article of the disclosure.

The embodiments of the first joined article of the disclosure are applicable to the second joined article of the disclosure.

### (Second substrate of the disclosure)

The second substrate of the disclosure includes the second joined article of the disclosure and a resin (2) stacked thereon.

Production of the second substrate of the disclosure includes heating at the heating temperature for the resin (2), as in the case of the first substrate of the disclosure. This effectively enables one-step production.

The resin (2) in the second substrate of the disclosure is the same as that in the first substrate of the disclosure.

The embodiments of the first substrate of the disclosure are applicable to the second substrate of the disclosure.

### EXAMPLES

The disclosure is described in more detail below with reference to examples, but is not limited to these examples.

The materials used in the examples are as follows.
Copper foil (electrodeposited copper, thickness: 12 um, surface roughness Rz of a surface to be joined: see Tables 1 and 2)
PFA film (thickness: 25 um, TFE/PAVE (% by mass): 96/4, melting point: 310°C, MFR: 14 g/10 min, surface treatment: see Tables 1 and 2 (in Examples 10 and 11 with surface treatment, plasma treatment was performed), relative permittivity: 2.1, dissipation factor: 0.001)

### (Linear expansion coefficient)

The linear expansion coefficient (linear expansion rate) of the PFA film was determined by TMA using TMA-7100 (available from Hitachi High-Tech Corp.) in the following mode.

### (Tensile mode measurement)

A sample piece having a length of 20 mm and a width of 4 mm was cut out of a 25-um-thick extruded film, and was stretched at a load of 49 mN and a temperature-increasing rate of 2°C/min from 30°C to 200°C. The displacement of sample was used to determine the linear expansion coefficient. The result was 213 ppm/°C.

### (Relative permittivity and dissipation factor)

The relative permittivity and dissipation factor were measured by a split cylinder resonator method. The split cylinders used were resonators supporting the respective frequencies available from EM labs, Inc. The network spectrum analyzer used was Keysight N5290A. The measurement target sample used was a film having a thickness of 25 um, a width of 62 mm, and a length of 75 mm. The measurement frequency was 10 GHz and the measurement temperature was 25°C.

### (Examples 1 to 11)

The copper foil and the PFA film were stacked. Quartz glass was placed on the fluororesin while a copper plate and a rubber sheet were placed in this order on the copper foil. The components were fixed at a pressure of about 1 MPa using flanges. A laser (fiber laser, absorbance of copper: see Table 3, absorbance of fluororesin: 5%) was applied from the side of the PFA film at a pitch of 0.11 to 0.23 mm every 2 seconds, whereby the copper foil was heated. The laser power and scanning speed conditions were as shown in Table 1. The laser spot size was 1 mm in every example. The laser wavelength was 1070 nm in every example.

The PFA film was melted via the heated copper foil, whereby a joined article including the copper foil and the PFA film joined together was provided.

### (Comparative Examples 1 to 3)

The copper foil and the PFA film were stacked and then pressed at a heating temperature of 320°C and a pressure of 3 MPa for 5 minutes, whereby a joined article including the copper foil and the PFA film joined together was obtained.

### (Comparative Examples 4 and 5)

A joined article including the copper foil and the PFA film joined together was obtained in the same manner as in Examples 1 to 11 except that the laser conditions were as shown in Table 2.

### (90-Degree peel test)

The 90-degree peel test was performed by the method in conformity with JIS C6481-1996.

The resin of the joined article obtained above was peeled at an end by about 1 cm and was held by a chuck of a tester. The peel strength (unit: N/cm) was measured under a tensile rate (moving rate) condition of 50 mm/min.

### (Curvature)

The joined article obtained above was cut to have dimensions of 45 × 5 mm, and the curvature was calculated from the curve in the longitudinal direction.

### (Thickness of heat-affected layer)

The joined article obtained above was cut in the width direction and the cross section of the resulting slice (cut width: 20 to 50 µm) was observed using a polarized optical microscope. Thereby, the thickness of the heat-affected layer in the PFA film close to the metal was measured. The results were expressed by the percentage (%) relative to the whole thickness of the PFA film.

The result of the 90-degree peel test, the curvature, and the thickness of the heat-affected layer for the joined articles obtained above are shown in Tables 1 and 2. In Comparative Example 4, the power was as high as 100 W and the scanning speed was low. This resulted in a high power/(spot size × scanning speed) value and a high curvature. In Comparative Example 5, the power/(spot size × scanning speed) value was higher than in Comparative Example 4. This caused burning of the PFA film, resulting in a failure in measuring the peel strength and the curvature.

**[Table 1]**

| | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|
| Resin surface treatment | | None | None | None | None | None | None | None | None | None | Performed | Performed |
| Copper foil Rz (µm) | | 1.5 | 1.5 | 1.5 | 1.5 | 1.5 | 1.5 | 1.5 | 0.9 | 0.9 | 0.8 | 0.8 |
| Laser | Power (W) | 60 | 60 | 80 | 80 | 80 | 80 | 100 | 80 | 100 | 80 | 100 |
| | Scanning speed (mm/s) | 700 | 1000 | 700 | 800 | 1200 | 1900 | 1400 | 900 | 1100 | 450 | 550 |
| Curvature (fm) | | 9 | -4 | 35 | 14 | -4 | -30 | 1 | 10 | -6 | 20 | 30 |
| Peel strength (N/cm) | | > 3 | > 3 | > 3 | > 3 | > 3 | > 3 | > 3 | Material failure | Material failure | > 3 | > 3 |
| Thickness of heat-affected layer (%) | | 35 | 25 | 45 | 40 | 25 | 15 | 30 | 35 | 25 | 40 | 45 |

**[Table 2]**

| | | Comparative Example 1 | Comparative Example 2 | Comparative Example 3 | Comparative Example 4 | Comparative Example 5 |
|---|---|---|---|---|---|---|
| Resin surface treatment | | None | None | Performed | None | None |
| Copper foil Rz (µm) | | 1.5 | 0.9 | 0.8 | 1.5 | 1.5 |
| Laser | Power (W) | - | - | - | 100 | 100 |
| | Scanning speed (mm/s) | - | - | - | 400 | 200 |
| Curvature (/m) | | 100 | 100 | 100 | 62 | Unable to measure |
| Peel strength (N/cm) | | > 3 | > 3 | > 3 | > 3 | Unable to measure |
| Thickness of heat-affected layer (%) | | 100 | 100 | 100 | > 95 | 100 |

**[Table 3]**

| | | | |
|---|---|---|---|
| Rz | 1.5 µm | 0.9 µm | 0.8 µm |
| Absorbance (%) | 57 | 22 | 19 |

### REFERENCE SIGNS LIST

10: laminate for substrate
11: core layer
12: fluororesin, resin (1)
13: metal
13a: high-temperature portion
14: single-sided joined article
100: pressing device
101: resin-side roll
102: metal-side roll
200: light

## Claims

1. A joined article comprising:
a resin (1) having a linear expansion coefficient at 30°C to 200°C of 17 ppm/°C or higher and a thickness of 5 to 100 um; and
a metal joined to a surface of the resin (1) and having a thickness of 5 to 50 um,
the joined article having a curvature of -40 to 40/m.

2. The joined article according to claim 1,
wherein the resin (1) comprises a fluororesin.

3. The joined article according to claim 2,
wherein the resin (1) consists essentially of the fluororesin.

4. The joined article according to claim 2 or 3,
wherein the fluororesin has a melting point of 320°C or lower.

5. The joined article according to any one of claims 1 to 4,
wherein the metal comprises copper.

6. The joined article according to claim 5,
wherein the copper is rolled copper or electrodeposited copper.

7. The joined article according to any one of claims 1 to 6,
wherein the joined article has a ratio (the thickness of the metal)/(the thickness of the resin (1)) of 0.1 to 1.

8. The joined article according to any one of claims 1 to 7,
wherein the resin (1) and the metal are joined together using light that is absorbed by the metal at an absorbance of 5% or higher and absorbed by the resin (1) at an absorbance of 30% or lower, with an inequality (the absorbance of the metal) > (the absorbance of the resin (1)) satisfied.

9. The joined article according to any one of claims 1 to 8,
wherein the joined article has a joined surface between the resin (1) and the metal, and the joined surface has a peel strength of 3 N/cm or higher measured in a 90-degree peel test or exhibits material failure in a 90-degree peel test.

10. The joined article according to any one of claims 1 to 9,
wherein the metal has a surface roughness Rz of 2 um or lower at a surface joined to the resin (1).

11. The joined article according to any one of claims 1 to 10,
wherein the resin (1) has been subjected to an adhesive surface treatment at a surface joined to the metal.

12. The joined article according to any one of claims 1 to 11, which is a dielectric material for a substrate.

13. A substrate comprising:
the joined article according to any one of claims 1 to 12; and
a resin (2) stacked on the joined article.

14. The substrate according to claim 13,
wherein the resin (2) comprises a thermosetting resin.

15. The substrate according to claim 14,
wherein the thermosetting resin includes at least one selected from the group consisting of polyimide, modified polyimide, epoxy resin, and thermosetting modified polyphenylene ether.

16. The substrate according to claim 13,
wherein the resin (2) includes at least one selected from the group consisting of a liquid crystal polymer, polyphenylene ether, thermoplastic modified polyphenylene ether, a cycloolefin polymer, a cycloolefin copolymer, polystyrene, and syndiotactic polystyrene.

17. The substrate according to any one of claims 13 to 16, which is a printed circuit board, a multilayer circuit board, or a high frequency board.

18. A method for producing a joined article, the method comprising:
stacking a resin (1) having a thickness of 5 to 100 um and a linear expansion coefficient at 30°C to 200°C of 17 ppm/°C or higher and a metal having a thickness of 5 to 50 um; and
joining the resin (1) and the metal by heating the resin (1) via the metal to provide a joined article having a curvature of -40 to 40/m.

19. The method for producing a joined article according to claim 18,
wherein the heating includes applying light to the metal.

20. The method for producing a joined article according to claim 19,
wherein the light is absorbed by the metal at an absorbance of 5% or higher and absorbed by the resin (1) at an absorbance of 30% or lower, with an inequality (the absorbance of the metal) > (the absorbance of the resin (1)) satisfied.

21. The method for producing a joined article according to any one of claims 18 to 20,
wherein the joined article is a dielectric material for a substrate.

22. A method for producing a substrate, the method comprising:
joining a joined article obtained by the production method according to any one of claims 18 to 21 and a resin (2) .

23. The method for producing a substrate according to claim 22,
wherein the resin (2) comprises a thermosetting resin.

24. The method for producing a substrate according to claim 23,
wherein the thermosetting resin includes at least one selected from the group consisting of polyimide, modified polyimide, epoxy resin, and thermosetting modified polyphenylene ether.

25. The method for producing a substrate according to claim 22, wherein the resin (2) includes at least one selected from the group consisting of a liquid crystal polymer, polyphenylene ether, thermoplastic modified polyphenylene ether, a cycloolefin polymer, a cycloolefin copolymer, polystyrene, and syndiotactic polystyrene.

26. The method for producing a substrate according to any one of claims 22 to 25,
wherein the substrate is a printed circuit board, a multilayer circuit board, or a high frequency board.

27. A joined article comprising:
a resin (1) having a linear expansion coefficient at 30°C to 200°C of 17 ppm/°C or higher and a thickness of 5 to 100 um; and
a metal joined to a surface of the resin (1) and having a thickness of 5 to 50 um,
the resin (1) including a heat-affected layer that is close to the metal and that occupies 80% or less of the thickness of the resin (1).

28. The joined article according to claim 27,
wherein the joined article has a curvature of -40 to 40/m.

29. The joined article according to claim 27 or 28,
wherein the resin (1) comprises a fluororesin.

30. The joined article according to claim 29,
wherein the resin (1) consists essentially of the fluororesin.

31. The joined article according to any one of claims 27 to 30,
wherein the metal comprises copper.

32. The joined article according to any one of claims 27 to 31,
wherein the joined article has a joined surface between the resin (1) and the metal, and the joined surface has a peel strength of 3 N/cm or higher measured in a 90-degree peel test or exhibits material failure in a 90-degree peel test.

33. The joined article according to any one of claims 27 to 32, which is a dielectric material for a substrate.

34. A substrate comprising:
the joined article according to any one of claims 27 to 33; and
a resin (2) stacked on the joined article.

35. The substrate according to claim 34,
wherein the resin (2) comprises a thermosetting resin.
